# EUROPÄISCHE PATENTANMELDUNG

(11) **EP 0 817 262 A2**
(43) Veröffentlichungstag der Anmeldung: **07.01.1998**
(21) Anmeldenummer: 97109589.8
(22) Anmeldetag: 12.06.1997
(51) Int. Cl.: H01L 23/433

(54) **Zusammengesetzter Leiterrahmen**

(30) Priorität: 25.06.1996 DE 19625384
(71) Anmelder: SIEMENS AKTIENGESELLSCHAFT, 80333 München (DE)
(72) Erfinder: Huska, Rochus, verstorben (DE)

(57) **Zusammenfassung**

Für die Herstellung von Leistungshalbleitergehäusen werden teilweise zusammengesetzte Leiterrahmen als Systemträger eingesetzt. Darin bestehen die zentralpositionierte Insel 4, die durch den Wärmeverteiler 2 dargestellt wird, und der restliche Leiterrahmen 1 aus Blechen unterschiedlicher Stärke. Die notwendige Verbindung zwischen Insel 4 und Leiterrahmen 1 wird durch eine Schweißverbindung dargestellt.

## Beschreibung

Die Erfindung betrifft einen Leiterrahmen zum Einsatz in einem Leistungshalbleiter-Bauelement. Dieser ist zur Verteilung und Ableitung der im elektronischen Bauelement entstehenden Wärme mit einem Wärmeverteiler verbunden, der zumindest teilweise mit in ein Kunststoffgehäuse integriert wird.

Eine starke Erwärmung eines elektronischen Bauelementes (Chip) muß je nach Gehäusetyp unterschiedlich beherrscht werden. Liegt beispielsweise ein elektronisches Bauelement mit einer Kunststoffumhüllung vor, so kann eine wirksame Wärmeableitung lediglich durch Wärmeleitung über entsprechende metallische Komponenten geschehen.Die Wärmeableitung über den Kunststoff des Gehäuses reicht lediglich für Bauteile aus, deren interne Wärmerzeugung relativ gering ist. An einem als Leistungschip bezeichneten elektronischen Bauteil ist jedoch im Unterschied zu CMOS-Schaltungen ein hoher passiver Kühlaufwand erforderlich. In diesem Zusammenhang wird ein relativ großes Metallstück als Wärmeverteiler (heatslug) in das Kunststoffgehäuse integriert und mit Klebstoff oder Lot mit der Wärmequelle (Chip) verbunden. Zur Gewährleistung einer hohen Wärmeabfuhr werden für die Metallteile beispielsweise Kupfer oder Kupferlegierungen verwendet. Bei der Materialauswahl für den Leiterrahmen ist ein Kompromiß in der Form notwendig, so daß einerseits eine gute Wärmeleitfähigkeit gewährleistet sein soll, andererseits aber auch die im Leiterrahmen integrierten Anschlußbeinchen gut biegbar und verlötbar sein müssen. Die Materialstärke des auch als Systemträger bezeichneten Leiterrahmens beträgt dabei beispielsweise 0,25 mm. Die Materialstärke des Wärmeverteilers liegt beispielsweise bei 1,3 mm.

Bei der Herstellung eines Kunststoffgehäuses muß in der Regel vor dem Spritzvorgang eine Einheit aus Chip, Wärmeverteiler und Wärmesenke vorliegen. Dies wird in der Fertigung dadurch erreicht, daß eine Vielzahl von Leiterrahmen hintereinander in einem zusammenhängenden Band verschiedenen Bearbeitungsstationen zugeführt wird. Korrespondierend dazu werden jeweils auf den zentralen als Insel bezeichneten Teil eines jeden Leiterrahmens fertigstrukturierte Halbleiterelemente aufgebracht und elektrisch innerhalb des Leiterrahmens verbunden. Die Zuführung und Befestigung eines Wärmeverteilers muß in der Fertigung ebenfalls aufeinanderfolgend an jeder Einheit von Leiterrahmen und Chip geschehen, wobei Wärmeverteiler und Leiterrahmen verbunden sein sollten. Nachdem die Herstellung eines Leiterrahmens, also eines Metallbandes, mit unterschiedlichen Stärken an unterschiedlichen Stellen sehr aufwendig bzw. unmöglich ist, müssen Wärmesenke und Leiterrahmen aus zwei Bestandteilen zusammengesetzt werden.

Es ist bekannt, unterschiedliche Metallbänder mit unterschiedlicher Dicke in jeweils vorgegebener Weise zu strukturieren und beide durch einen Krimpvorgang zu verbinden. Eine andere Möglichkeit besteht in der Herstellung der Verbindung durch eine Niete. Derartige Krimp- bzw. Nietverbindungen sind jedoch von relativ schlechter Qualität. Insbesondere kann eine dauerhafte elektrische Verbindung zwischen Insel (= Wärmeverteiler) und Leiterrahmen nicht gewährleistet werden.

Der Erfindung liegt die Aufgabe zugrunde, einen Leiterrahmen mit Wärmeverteiler zur Verfügung zu stellen, wobei die Insel des Leiterrahmens eine gute Wärmeableitung gewährleistet und gleichzeitig zuverlässig und dauerhaft elektrisch mit Masse verbunden ist.

Die Lösung dieser Aufgabe wird durch die Merkmale des Anspruchs 1 dargestellt.

Die Erfindung führt zu dem Erfolg, daß der Systemträger oder Leiterrahmen mit dem Wärmeverteiler der zur Wärmeableitung der in einem Halbleiterelement entstehenden Betriebswärme dient zuverlässig durch eine Schweißverbindung zusammenmontiert werden können. Nachdem der Einbau des Wärmeverteilers aufgrund der Wärmeentwicklung des Halbleiterchips nowendig ist, muß eine technische Lösung zur Herstellung der mechanischen Stabilität der Anordnung aus Leiterrahmen und Halbleiterchip angeboten werden. Wie im Stand der Technik beschrieben, läßt sich ein dazu notwendiger Leiterrahmen mit unterschiedlichen Blechdicken an verschiedenen Stellen nicht in einem Stück herstellen. Somit ist der Einsatz eines zusammmengesetzten Leiterrahmens, in dem der Wärmeverteiler als Insel eingebaut wird unumgänglich. Unabhängig von den Eigenschaften des Wärmeverteilers muß die Insel zur Bereitstellung des Massekontaktes mit einem Anschlußbeinchen, das für den Massekontakt eingesetzt wird, zuverlässig verbunden werden. Hierzu wird die Insel bzw. der Wärmeverteiler mittels einer Schweißverbindung mit dem Leiterrahmen verbunden.

In vorteilhafterweise kann diese Schweißverbindung durch eine Laserschweißung dargestellt werden.

Leiterrahmen und Wärmeverteiler sind unter Umständen großflächig aneinander gelegt, so daß sich an genugenden Stellen überlappende Bereiche ergeben, an denen eine Schweißung herstellbar ist. Als besondere Ausführungsformen für eine Laserschweißung liegt entweder eine Kantenschweißung an einer Außenseite, d.h. an einer Schmalseite, des Wärmevertelers vor oder eine Kantenschweißung an einer Innenseite einer Aussparung des Wärmeverteilers. Die Besonderheit ist in beiden Fällen die Herstellung einer kehlnahtförmigen Schweißverbindung, wobei die zu verbindenden Teile flächig aneinanderliegen und die Stirnseite des dünneren Metallstreifens, in diesem Fall des Leiterrahmens, auf der flächigen Seite des Wärmeverteilers angeschweißt ist.

Im folgenden wird anhand der drei schematischen Figuren ein Ausführungsbeispiel beschrieben.

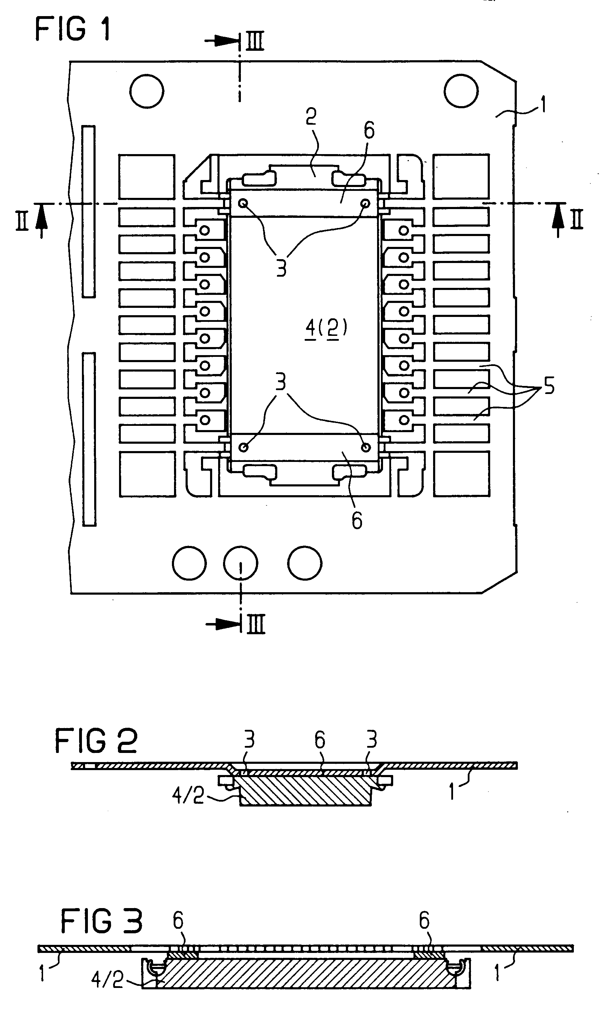

Die Figur 1 zeigt einen Leiterrahmen (leadframe assembly). Darin ist zum einen ein strukturierter Leiterrahmen 1 dargestellt, der in der Fertigung in einer Vielzahl hintereinander in einem Metallstreifen bereitgestellt wird. Zum anderen wird zu jedem Leiterrahmen 1 ein Wärmeverteiler 2 hinzugefügt. Zur Verbindung dieser beiden Bauteile wurde im Stand der Technik beispielsweise eine Krimp-Verbindung verwendet. Erfindungsgemäß sind der Leiterrahmen 1 und der Wärmeverteiler 2 über eine Schweißverbindung 2, insbesondere eine Laserschweißverbindung, an mehreren Stellen miteinander verbunden. Der Leiterrahmen 1 weist eine zentral positionierte integrierte Insel 4 auf, die zur Aufnahme des Halbleiterelementes dient und durch den Wärmeverteiler 2 dargestellt wird.

Die Figuren 2 und 3 zeigen die entsprechenden Schnittdarstellungen aus der Figur 1. Darin ist wie in Figur 1 der die Insel 4 darstellende Wärmeverteiler 2 dargestellt. Der im Schnitt dargestellte Leiterrahmen 1 zeigt in Figur 2 einen sog. 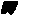 downset", wodurch der Steg 6 heruntergesetzt wird. In Figur 2 sind auch die Aussparungen 3 sichtbar, innerhalb der mittels Laserschweißung der Leiterrahmen 1 und der Wärmeverteiler 2 verbunden sind. Die Figur 3 zeigt eine gegenüber Figur 2 um 90° gedrehte Schnittdarstellung. Darin sind wiederum die Stege 6 erkennbar, mit denen der Leiterrahmen 1 mit dem Wärmeverteiler 2 aneinanderliegt. In Figur 3 sind im mittleren Bereich des Leiterrahmens 2 die Anschlußbeinchen des Leiterrahmens 1 erkennbar. Der zusammengesetzte Leiterrahmen 1 entsprechend der Erfindung gewährleistet, daß die Insel 4, die durch den für Leistungshalbleiterelemente notwendigen Wärmeverteiler 2 dargestellt wird, zuverlässig an Masse gelegt ist.

Die Materialstärke der Komponenten beträgt beispielsweise für den Leiterrahmen 1 0,25 mm und für den Wärmeverteiler 2 1,3 mm. Die besonderen Vorteile einer Laserschweißverbindung liegen darin, daß keinerlei Deformationen des Leiterrahmens 1 zu erwarten sind und daß eine feste Verbindung vorliegt,die beispielsweise einer Zugkraft von 40 N standhält. Die Stellen, an denen eine Schweißverbindung erzeugt wird, können gleichmäßig über eine Fläche oder gleichmäßig über den Umfang der Insel des Wärmeverteilers oder an besonders exponierten Stellen angeordnet werden. Mit einem Laserstrahl läßt sich auch eine Durchschweißung bei aufeinanderliegenden zu verbindenden, Blechstreifen erzeugen. Mittels eines Laserstrahles lassen sich an Stirnseiten, die auf dem anderen Verbindungspartner in irgendeiner Form aufliegen oder angrenzen, kehlnahtähnliche Verschweißungen erzeugen. Entsprechend der Figuren 1 und 2 können beispielsweise Aussparungen 3 innerhalb des Leiterrahmens 1 vorgesehen sein, in denen die beiden Verbindungspartner verschweißt werden. Diese Aussparungen 3, die hier als Kreise dargestellt sind, können beliebige Formen annehmen.

Durch die schweißtechnische Lösung entsprechend der Erfindung wird weiterhin der Vorteil erzielt, daß auf der Inseloberfläche eine ansonsten notwendige Silberschicht entfallen kann. Diese Silberschicht ist teilweise notwendig, um eine beispielsweise angenietete Insel mittels eines Bonddrahtes elektrisch zu verbinden. Die Einsparung der Silberschicht ergibt Kostenersparnisse und verbessert auch eine Klebeverbindung zwischen Halbleiterelement (hier nicht dargestellt) und der Insel 4. Die Erzeugung eines Bodenkontaktes ist jedoch nach wie vor möglich. Hierzu werden sog. Silberspots auf dem Leiterrahmen 1 aufgebracht. Ein Silberspot ist ein Silberauftrag passender Form um beispielsweise eine elektrische Verbindung zwischen dem Halbleiterelement und dem Leiterrahmen oder einem Teil davon herzustellen.

Nachdem elektrische Eigenschaften von Ausgangsmaterialien von Herstellern selten garantiert werden, läßt sich durch die zuverlässige Verbindung zwischen Leiterrahmen 1 und Wärmeverteiler 2 ein einheitlicher Aufbau für eine Halbleiteranordnung mit entsprechender Wärmeabfuhr mit gleichzeitiger interner elektrischer Verbindung darstellen.

Eine Aussparung 3 kann beispielsweise schlitzförmig dargestellt werden mit den Abmaßen 0,25 mm x 2 mm. Der fokussierte Laserstrahl wird auf die Schlitzmitte ausgerichtet, wobei an beiden Schmalseiten des Leiterrahmens 1 innerhalb der Aussparung 3 eine Schweißverbindung erzeugbar ist. Prinzipiell sind mittels Laserschweißung gute Bruchfestigkeitswerte in der Verbindungszone erzielbar. Der Laser ist universell einsetzbar und kann gleichbleibend stabile Verbindungen mit hohen Festigkeitswerten erzeugen, wenn unterschiedliche Absorptionsverhältnisse an verschiedenen Stellen eines Werkstückes nicht zu unterschiedlichen Einkopplungen der Laserleistung führen. Ein Laserschweißverfahren ist ständig verfügbar und bietet wirtschaftliche Vorteile.

### Bezugszeichenliste

- 1: Leiterrahmen (leadframe)
- 2: Wärmeverteiler (headslug)
- 3: Aussparung, Durchgang
- 4: Insel
- 5: Anschlußbeinchen
- 6: Steg

## Patentansprüche

1. Zusammengesetzter Leiterrahmen (1) zur Montage von elektronischen Leistungs-Halbleiter-Bauelementen, bestehend aus einem strukturierten Metallstreifen mit bestimmter Materialstärke, an dem innere und äußere elektrische Anschlußelemente dargestellt sind, mit einem angeschlossenen flächig ausgebildeten Wärmeverteiler (2), der eine größere Materialstärke als der Leiterrahnen (1) aufweist, wobei Wärmeverteiler (2) und Leiterrahmen (1) durch mindestens eine Schweißverbindung miteinander verbunden sind und der Wärmeverteiler (2) gleichzeitig eine zentral im Leiterrahmen (1) positionierte Insel (4) darstellt, die zur Montage von Halbleiterelementen vollflächig oder partiell ausgebildet ist.

2. Leiterrahmen nach Anspruch 1, worin die Verbindung zwischen Leiterrahmen (1) und Wärmeverteiler (2) durch eine oder mehrere Laserschweißungen dargestellt ist.

3. Leiterrahmen nach einem der vorhergehenden Ansprüche, worin der Leiterrahmen (1) den Wärmeverteiler (2) überdeckende Stege (6) aufweist, die mit mindestens einem Durchgang (3) versehen sind, wobei die Schweißverbindung am Zusammentreffen des Wärmeverteilers (2) mit dem entsprechenden Rand des Durchganges (3) dargestellt ist.

4. Leiterrahmen nach einem der vorhergehenden Ansprüche, worin Leiterrahmen (1) und Wärmeverteiler (2) großflächig aneinanderliegen.

5. Leiterrahmen nach einem der vorhergehenden Ansprüche, worin die Schweißverbindung zwischen einer Schmalseite des Leiterrahmens (1) und einer flächigen Seite des Wärmeverteilers (2) dargestellt ist.
